## Europäisches Patentamt

## European Patent Office

## Office européen des brevets

(11) Publication number: **0 148 506**

**B1**

(12) # EUROPEAN PATENT SPECIFICATION

(45) Date of publication of patent specification: **02.11.88**

(21) Application number: **84116410.6**

(22) Date of filing: **27.12.84**

(51) Int. Cl.⁴: **H 01 C 13/02,** H 01 C 1/142, H 01 L 25/16

(54) **Circuit board.**

(30) Priority: **26.12.83 JP 243857/83**

(43) Date of publication of application:
**17.07.85 Bulletin 85/29**

(45) Publication of the grant of the patent:
**02.11.88 Bulletin 88/44**

(84) Designated Contracting States:
**DE FR GB**

(58) References cited:
US-A-2 777 039
US-A-2 994 846

IBM TECHNICAL DISCLOSURE BULLETIN, vol. 23, no. 5, October 1980, pages 1835,1836, New York, US; J. GOW III et al.: "MLC top surface metallurgy with Cr/SiO resistros"

(73) Proprietor: **HITACHI, LTD.**
**6, Kanda Surugadai 4-chome Chiyoda-ku Tokyo 100 (JP)**

(72) Inventor: **Tanaka, Minoru**
**33-12, Hirato-2-chome**
**Totsuka-ku Yokohama (JP)**
Inventor: **Hirota, Kazuo**
**910-11, Hamanogo**
**Chigasaki-shi (JP)**
Inventor: **Murata, Akira**
**2-2, Torigoe-1-chome**
**Taito-ku Tokyo (JP)**
Inventor: **Kobayashi, Fumiuki**
**5-13, sahicho**
**Sagamihara-shi (JP)**
Inventor: **Takenaka, Takaji**
**1523-6, Hirasawa**
**Hadano-shi (JP)**

(74) Representative: **Frohwitter, Bernhard, Dipl.-Ing. et al**
**Bardehle-Pagenberg-Dost-Altenburg & Partner**
**Patent- und Rechtsanwälte Galileiplatz 1**
**8000 München 80 (DE)**

## Description

The present invention relates to a circuit board to install electronic parts and, more particularly, to structures of resistors which are formed on the board.

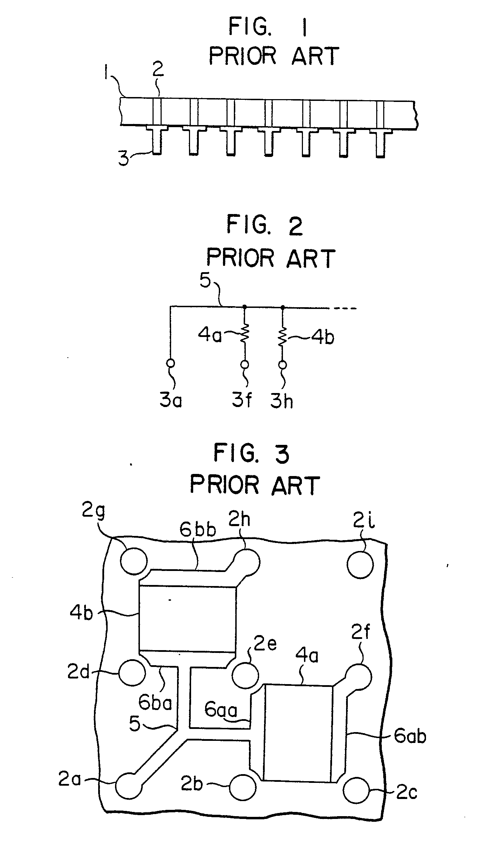

A circuit board on which resistors are formed will now be described with reference to Fig. 1. Fig. 1 shows a cross sectional view of a circuit board which is constituted by a board 1 made of ceramics or the like, through hole conductors 2 piercing the board 1, and lead pins 3 which are electrically and mechanically connected to the through hole conductors 2 and which transmit and receive signals to and from the outside.

Resistors are formed on the upper surface of the board 1 of the foregoing circuit board by way of the sintering of thick film paste material or the thin film process such as evaporation deposition, sputtering, and etc.

An example of a resistor circuit will be explained with reference to Fig. 2.

Each end of resistors 4a and 4b is connected to a lead pin 3a through a common lead line 5, while each of the other ends of the resistors 4a and 4b is connected to lead pins 3f and 3h.

A conventional example whereby the resistor circuit as shown in Fig. 2 is formed on the circuit board of Fig. 1 will be described with reference to Fig. 3.

Fig. 3 shows a partial plan view on the board 1 in Fig. 1 and illustrates a resistor circuit pattern and the through hole conductors which are arranged like a lattice.

Reference numerals 6aa, 6ab, 6ba, and 6bb denote electrodes of the resistors 4a and 4b. The electrodes 6aa and 6ba on the side of each end of the resistors 4a and 4b are respectively connected to a through hole conductor 2a through the common lead line 5, while the electrodes 6ab and 6bb on the side of the other ends are respectively connected to through hole conductors 2f and 2h. The through hole conductors 2a, 2f and 2h are respectively connected to the corresponding lead pins 3a, 3f and 3h shown in Fig. 2. Numerals 2b to 2e, 2g, and 2i indicate independent through hole conductors which are not connected to the resistor circuit pattern but are used for the processes of other signals.

As is well known, in the arrangement of the conventional resistors 4, each square-shaped resistor is formed at the position surrounded by the lattice of the four through hole conductors 2 as mentioned above. However, such a conventional arrangement method has the following drawback.

As shown in Fig. 3, in the case where the position of the common terminal of the resistors 4a and 4b is designated as the through hole conductor 2a, for instance, if it is desired to form the resistor 4 as well at the position surrounded by the through hole conductors 2a, 2b, 2d, and 2e and thereby to use the through hole conductor 2d or 2e as one terminal, the resistor 4 cannot be formed since the common lead line 5 exists.

Namely, there is a drawback such that a resistor cannot be formed at an arbitrary position on the surface of the board 1.

It is an object of the present invention to eliminate the above-mentioned conventional drawback and to provide a circuit board in which resistors can be arranged at arbitrary positions on the board.

In consideration of the above object, the present invention has a feature such that the resistors on the circuit board have circular shapes and each resistor is formed like a disk in which one electrode is arranged at the center of the resistor and the other electrode is arranged in the whole outer peripheral portion of the circle.

The present invention will be apparent from the following detailed description taken in conjunction with the accompanying drawings, in which:

Fig. 1 is a cross sectional view of an ordinary circuit board;

Fig. 2 is a diagram showing an ordinary resistor circuit;

Fig. 3 is a plan view of a conventional circuit board on which a resistor circuit is formed;

Fig. 4 is a plan view showing one embodiment of a circuit board according to the present invention;

Figs. 5A to 5C are cross sectional views taken along the lines A—A', B—B' and C—C' of Fig. 4, respectively;

Fig. 6 is a perspective view in which the invention is applied to a multilayer board; and

Fig. 7 is a perspective view in which parts of the inner layers of Fig. 6 are enlarged.

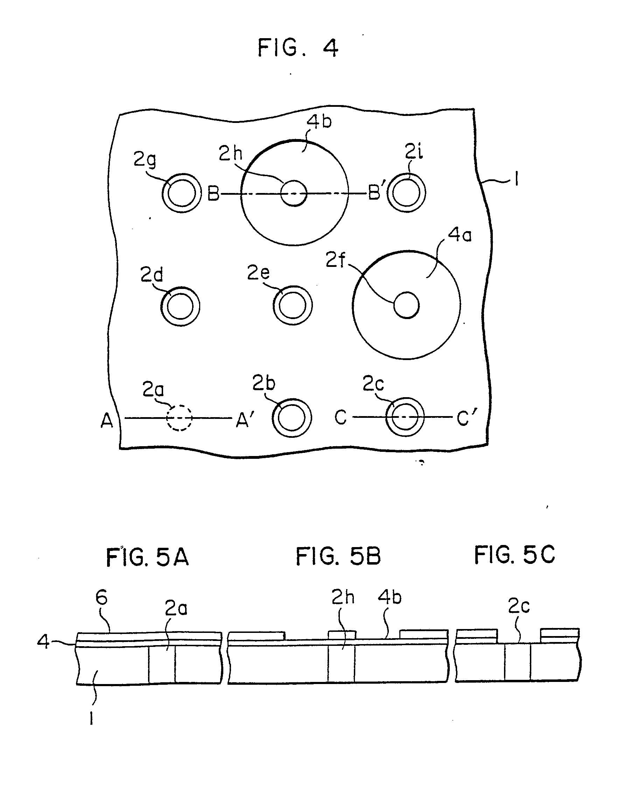

One embodiment of the present invention will now be described hereinbelow with reference to Figs. 4 and 5. Similarly to the circuit board shown in Fig. 3, Fig. 4 shows a circuit board in which the resistors 4a and 4b are arranged on the surface of the board 1, in which the functions of the other component elements are substantially the same as those in case of Fig. 3. However, the common lead line 5 and the elements of the electrodes 6 in Fig. 3 are not shown.

Figs. 5A to 5C show cross sectional views taken along the lines A—A', B—B' and C—C' in Fig. 4, in which the electrode 6 also commonly serves as the function of the common lead line 5 in Fig. 3.

A method of manufacturing a circuit board will be first described. In Fig. 5, the resistor 4 for the resistors 4a and 4b is formed like a film on the overall surface of the board 1. Then, the electrode 6 is formed like a film on the whole surface of the film resistor 4. To form the resistor 4b in Fig. 4, the film of the electrode 6 having a predetermined radius is removed coaxially with the through hole conductor 2h due to means such as an etching process or the like. Due to this, the through hole conductor 2h commonly serves as one electrode of the resistor 4b, that is, the electrode 6bb connected to the through hole conductor 2h in Fig. 3. The remaining film of the electrode 6 in the outer peripheral portion of the resistor 4b becomes the other electrode and commonly serves as the common lead line 5 in Fig. 3.

The films of the resistor 4 and electrode 6 on the through hole conductor 2a in Fig. 5A are left as they are, thereby performing the same function as the through hole conductor 2a in Fig. 3.

On the other hand, by removing the films of the resistor 4 and electrode 6 in the peripheral portion on the surface of the through hole conductor 2c in Fig. 5C, the through hole conductor which is independent of the pattern of the resistor circuit is obtained similarly to the through hole conductor 2c in Fig. 3.

In addition, only the coaxial resistor in the periphery of the through hole conductor 2h shown in Figs. 4 and 5B among the film-shaped resistors 4 shown in Figs. 5A and 5B contributes substantially as the resistor 4b. Namely, the electrical circuit across the through hole conductors 2h and 2a starts from the through hole conductor 2h, passes through as the resistor 4b through the resistor 4 until the electrode 6 which is closest to the through hole conductor 2h, and ends at the through hole conductor 2a shown in Fig. 5A through the electrode 6. Although the resistor 4 of a microdistance is interposed between the electrode 6 and the through hole conductor as shown in Fig. 5A, a thickness of the resistor 4 is so thin that the resistance value of this portion can be ignored. Therefore, to make the resistance value of the resistor 4b variable, the radius of the resistor 4b shown in Fig. 4 and the specific resistance of the resistor 4 itself can be used as parameters.

With such an arrangement as described above, similarly to the conventional embodiment of Fig. 3, the embodiment of Fig. 4 can have substantially the same function as the resistor circuit pattern as that shown in Fig. 2.

In Fig. 4, it is also possible to form a circular resistor corresponding to the resistor 4b in the region surrounded by the through hole conductors 2a, 2b, 2d, and 2e without coming into contact with the respective through hole conductors and to put out the central electrode responsive to the through hole conductor 2h from the upper portion. Such a structure is advantageous in case of further piling other circuit layers over the resistor circuit shown in Fig. 5.

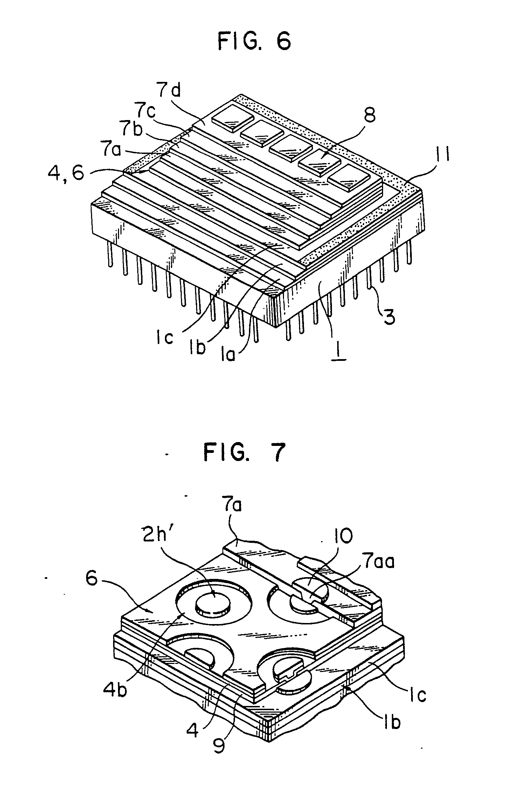

An embodiment whereby circuit layers are further piled over the resistor circuit will then be explained with reference to Figs. 6 and 7.

Fig. 6 is a perspective view illustrating the whole multilayer board with a part cut away. The foregoing resistor circuit layers 4 and 6 are formed over the ceramic multilayer board 1 (1a to 1c) which is formed of conductive material due to a print sintering process or the like. Further, thin film wiring layers 7 are formed on and over the layers 4 and 6 due to what is called a thin film process such as the film formation by way of a sputtering process, pattern formation by way of a photo etching process, or the like.

Fig. 7 is a partially enlarged perspective view of Fig. 6. As already described in conjunction with the cross sectional view of Fig. 5, the resistor 4 is formed like the film on the whole surface. However, in this embodiment, a resistor underlayer 9 is formed under the resistor 4. The underlayer 9 is interposed in order to make the concave and convex portions of the surfaces of the board 1c flat and to prevent that the impurities are diffused from the board 1c into the resistor film 4. As the underlayer 9, it is possible to use the material which is formed by heating and curing polyimide system resin like varnish after it was coated due to a spin process or to use glass material.

A numeral 2h′ denotes an individual electrode of the resistor. As shown in Fig. 5B, this electrode is formed by allowing the electrode 6 on the through hole conductor to remain upon etching of the film of the electrode 6. To further forming the wiring layers over those resistor circuit layers, an insulation layer 7a consisting of polyimide resin or the like is first formed in a similar manner as the foregoing resistor underlayer 9; a through hole 7aa is formed in the portion corresponding to the individual electrode 2h′; and a through hole conductor 10 is further formed in this portion. This conductor 10 serves as the electrical connecting point to thin film wiring layers 7b, 7c and 7d, etc. in Fig. 6.

Fig. 6 shows the state in that electronic parts 8 such as integrated circuits, transistors or the like are installed on the top layer 7d of the thin film wiring layers. On the other hand, the resistor circuit layers 4 and 6 and thin film wiring layers 7 are constituted so as to have smaller area than the region surrounded by the frame of the board 1. The reason of this arrangement is to provide a sealing metallized layer 11 in the outer peripheral portion of the top layer 1c of the board 1. A sealing cap (not shown) is joined in accordance with this metallized layer 11.

As described above, according to the present invention, the surface of an arbitrary through hole conductor 2 on the surface of the board 1 can be used as the electrode for the resistor 4; a degree of freedom in designing of the circuit such as terminal resistors or the like and in designing of the pattern of the board can be improved; and a density of installation on the board can be remarkably improved.

On the other hand, in the foregoing embodiment, the example of the terminal resistor whereby all of the resistors 4a and 4b are connected to the electrode 6 has been explained. However, for instance, if the electrode 6 is divided into the electrodes for coupling of the individual through hole conductors, each resistor can be obviously used as the independent resistor element.

## Claims

1. A circuit board arrangement comprising at least one circuit board, said circuit board comprising:

a substrate (1) having a plurality of circular through-holes therethrough;

resistance means including a resistance layer (4) formed on said substrate (1);

first electrode means including a plurality of circular through-hole conductors (2; 2a, 2b, 2c, 2d, 2e, 2f, 2g, 2h, 2i, 7aa) respectively formed on said board through said through-holes, and a plurality of substantially circular electrode elements (2h') formed on said resistance layer (4) and substantially respectively aligned with at least some of said through-hole conductors; and

second electrode means including a conductive layer (6) formed on said resistance layer (4) and having a plurality of circular holes respectively substantially coaxial with at least some of said through-hole conductors, each of said circular holes having a radius greater than a radius of the circular electrode elements (2h').

2. A circuit board comprising at least:

(a) a board (1) having a plurality of through-hole conductors (2; 2a, 2b, 2c, 2d, 2e, 2f, 2g, 2h, 2i, 7aa) therein;

(b) resistors (4, 4a, 4b) formed on one surface of said board so as to be electrically connected to at least some of through hole conductors of said board; and

(c) an electrode (6) formed on the surface of said resistors, said electrode being removed except for portions (2h') located coaxially with the through-hole conductors to which the resistors are connected and except for a common electrode surrounding said portions so that said resistors are exposed at the removed portions of the electrode, said portions (2h') located coaxially with said through-holes constituting individual electrodes.

3. A circuit board according to claim 2, wherein individual electronic circuit elements (8) are connected to said individual electrodes.

4. A circuit board comprising:

a multilayer board (1a; 1b; 1c);

a resistance layer (4) formed on said multilayer board;

a plurality of substantially circular first electrodes (2h') formed on said resistance layer (4);

a second electrode element including a conductor layer (6) formed on said resistance layer (4), said conductor layer (6) having a plurality of circular holes formed therein respectively coaxially with substantially circular first electrodes (2h'), each of said circular holes having a radius larger than a radius of said circular first electrodes; and

a wiring layer (7b, 7c, 7d) having a plurality of through hole conductors (7aa) respectively formed substantially aligned with said first electrodes (2h'), said wiring layer being formed to cover said first and second electrodes (2h', 6).

5. A circuit board according to Claim 4, wherein an underlayer (9) is formed between said multilayer board (1a, 1b, 1c) and said resistance layer (4).

6. A circuit board according to Claim 4, wherein a radius of said first electrode (2h') is larger than a radius of said through-hole conductors.

**Patentansprüche**

1. Schaltungsplattenanordnung mit mindestens einer Schaltungsplatte, welche aufweist:

ein Substrat (1) mit einer Vielzahl von kreisförmigen Durchgangslöchern;

Widerstandseinrichtungen mit einer Widerstandsschicht (4), welche auf dem Substrat (1) gebildet ist;

erste Elektrodeneinrichtungen mit einer Vielzahl von kreisförmigen Durchgangsloch-Leitern (2; 2a, 2b, 2c, 2d, 2e, 2f, 2g, 2h, 2i, 7aa), welche jeweils auf der Platte durch die Durchgangslöcher geformt sind, und mit einer Vielzahl von im wesentlichen kreisförmigen Elektrodenelementen (2h'), welche auf der Widerstandsschicht (4) gebildet und im wesentlichen jeweils mit mindestens einigen der Durchgangsloch-Leitern ausgerichtet sind; und

zweite Elektrodeneinrichtungen mit einer leitfähigen Schicht (6), welche auf der Widerstandsschicht (4) gebildet ist und eine Vielzahl von kreisförmigen Löchern hat, welche jeweils im wesentlichen koaxial mit mindestens einigen der Durchgangsloch-Leitern sind, wobei jedes der kreisförmigen Löcher einen Radius aufweist, welcher größer als ein Radius der kreisförmigen Elektrodenelemente (2h') ist.

2. Schaltungsplatte, welche mindestens aufweist:

(a) eine Platte (1) mit einer Vielzahl von Durchgangsloch-Leitern (2; 2a, 2b, 2c, 2d, 2e, 2f, 2g, 2h, 2i, 7aa);

(b) Widerstände (4, 4a, 4b), welche auf einer Oberfläche der Platte geformt sind, um elektrisch mit mindestens einigen der Durchgangsloch-Leitern der Platte verbunden zu sein;

(c) eine Elektrode (6), welche auf der Oberfläche der Widerstände geformt ist, wobei die Elektrode entfernt ist mit Ausnahme von Abschnitten (2h'), welche koaxial mit den Durchgangsloch-Leitern angeordnet sind, mit welchen die Widerstände verbunden sind, und mit Ausnahme einer gemeinsamen Elektrode, welche diese Abschnitte umgibt, so daß die Widerstände an den entfernten Abschnitten der Elektrode freigelegt sind, wobei die Abschnitte (2h') koaxial mit den die einzelnen Elektroden bildenden Durchgangslöchern angeordnet sind.

3. Schaltungsplatte nach Anspruch 2, bei welcher die einzelnen elektronischen Schaltungselemente (8) mit den einzelnen Elektroden verbunden sind.

4. Schaltungsplatte, welche aufweist:

eine Vielschichtplatte (1a; 1b; 1c);

eine Widerstandsschicht (4), welche auf der Vielschichtplatte geformt ist;

eine Vielzahl von im wesentlichen kreisförmigen ersten Elektroden (2h'), welche auf der Widerstandsschicht (4) gebildet sind;

ein zweites Elektrodenelement mit einer Leiterschicht (6), welche auf der Widerstandsschicht (4) gebildet ist, wobei die Leiterschicht (6) eine Vielzahl von kreisförmigen Löchern aufweist, welche darin jeweils koaxial mit im wesentlichen kreisförmigen ersten Elektroden (2h') geformt sind, wobei jedes der kreisförmigen Löcher einen Radius aufweist, welcher größer ist als ein Radius der kreisförmigen ersten Elektroden;

eine Verdrahtungsschicht (7b, 7c, 7d) mit einer Vielzahl von Durchgangsloch-Leitern (7aa), welche jeweils im wesentlichen ausgerichtet mit den ersten Elektroden (2h') geformt sind, wobei die Verdrahtungsschicht geformt ist, um die ersten und zweiten Elektroden (2h', 6) zu bedekken.

5. Schaltungsplatte nach Anspruch 4, bei welcher eine Unterschicht (9) zwischen der Vielschichtplatte (1a, 1b, 1c) und der Widerstandsschicht (4) geformt ist.

6. Schaltungsplatte nach Anspruch 4, bei welcher ein Radius der ersten Elektroden (2h') größer ist als ein Radius der Durchgangsloch-Leiter.

**Revendications**

1. Agencement de panneau de circuits, comprenant au moins un panneau de circuits, ledit panneau de circuits comprenant:

un substrat (1) possédant une pluralité de trous traversants circulaires;

des moyens résistifs incluant une couche résistive (4) formée sur ledit substrat (1);

des premiers moyens formant électrode incluant une pluralité de conducteurs (2; 2a, 2b, 2c, 2d, 2e, 2f, 2g, 2h, 2i, 7aa) des trous traversants, formés respectivement sur ledit panneau et s'étendant dans lesdits trous traversants, une pluralité d'éléments d'électrode sensiblement circulaires (2h') formés sur ladite couche résistive (4) et sensiblement alignés respectivement avec au moins certains desdits conducteurs des trous traversants; et

des seconds moyens formant électrode incluant une couche conductrice (6) formée sur ladite couche résistive (4) et comportant une pluralité de trous circulaires respectivement sensiblement coaxiaux avec au moins certains desdits conducteurs des trous traversants, chacun desdits trous circulaires possédant un rayon supérieur à un rayon des éléments d'électrode circulaires (2h').

2. Panneau de circuits comprenant au moins:

(a) un panneau (1) comportant une pluralité de conducteurs (2, 2a, 2b, 2c, 2d, 2e, 2f, 2g, 2h, 2i, 7aa) situés dans les trous traversants;

(b) des résistances (4, 4a, 4b) formées sur une surface dudit panneau de manière à être raccordées électriquement à au moins certains des conducteurs des trous traversants dudit panneau; et

(c) une électrode (6) formée sur la surface desdites résistances, ladite électrode étant éliminée hormis au niveau de parties (2f') coaxiales aux conducteurs des trous traversants, auxquels les résistances sont raccordées, et hormis au niveau d'une électrode commune entourant lesdites parties de sorte que lesdites résistances sont à nu au niveau des parties éliminées de l'électrode, lesdites parties (2h') coaxiales auxdits trous traversants constituant des électrodes individuelles.

3. Panneau de circuits selon la revendication 2, dans lequel des éléments de circuits électroniques individuels (8) sont raccordés auxdites électrodes individuelles.

4. Panneau de circuits comprenant:
un panneau à couches multiples (1a; 1b; 1c);
une couche résistive (4) formée sur ledit panneau à couches multiples;
une pluralité de premières électrodes sensiblement circulaires (2h') formées sur ladite couche résistive (4),
un second élément d'électrode incluant une couche conductrice (6) formée sur ladite couche résistive (4), ladite couche conductrice (6) possédant une pluralité de trous circulaires formés en elle respectivement dans des positions coaxiales à des premières électrodes sensiblement circulaires (2h'), chacun desdits trous circulaires possédant un rayon supérieur à un rayon desdites premières électrodes circulaires; et
une couche de câblage (7b, 7c, 7d) comportant une pluralité de conducteurs (7aa) prévus dans les trous traversants et formés respectivement en étant sensiblement alignés avec lesdites premières électrodes (2h'), ladite couche de câblage étant formée de manière a recouvrir lesdites première et seconde électrodes (2h', 6).

5. Panneau de circuits selon la revendication 4, dans lequel une couche sous-jacente (9) est formée entre ledit panneau à couches multiples (1a, 1b, 1c) et ladite couche résistive (4).

6. Panneau de circuits selon la revendication 4, dans lequel un rayon de ladite première électrode (2h') est supérieur à un rayon desdits conducteurs des trous traversants.

# FIG. 1
## PRIOR ART

# FIG. 2
## PRIOR ART

# FIG. 3
## PRIOR ART

FIG. 4

FIG. 5A          FIG. 5B          FIG. 5C

# FIG. 6

# FIG. 7